# EUROPEAN PATENT APPLICATION

(11) **EP 0 935 171 A1**
(43) Date of publication of application: **11.08.1999**
(21) Application number: 99300871.3
(22) Date of filing: 05.02.1999
(51) Int. Cl.: G03F 7/033

(54) **Photoimageable compositions having hydrophilic binder polymers and hydrophilic monomers**

(30) Priority: 06.02.1998 US 19540
(71) Applicant: MORTON INTERNATIONAL, INC., Chicago, Illinois 60606 (US)
(72) Inventor: Barr, Robert, Laguna Niguel, CA 92677 (US)
(74) Representative: Bankes, Stephen Charles Digby

(57) **Abstract**

A negative acting photoimageable composition comprising an acid functional binder polymer also having substantial hydroxyl functionality, photopolymerizable α,β-ethylenically unsaturated compound(s) including a compound(s) having multi α,β-ethylenic unsaturated functionality and at least 3 ethylene glycol and/or propylene glycol units per molecule, and photoinitiator.

## Description

The present invention is directed to negative-acting photoimageable compositions such as those used as photoresists used to form printed circuit boards. The photoimageable compositions utilize a hydrophilic binder polymer along with a hydrophilic monomer component.

### Background of the Invention

This invention is directed to negative-acting photoimageable compositions which are developable in alkaline aqueous solutions. The invention is particularly applicable to primary photoimaging resists, but is applicable, as well, to compositions that are hardenable so as to form solder masks and the like.

A variety of such photoimageable compositions are described. Essential compositions of the type to which the present invention is directed are A) a binder polymer; B) photopolymerizable α,β-ethylenically unsaturated compound(s), and C) a photoinitiator chemical system. The binder polymer A) has sufficient acid functionality, generally carboxylic acid functionality, that it is soluble in alkaline aqueous solution and thereby renders the photoimageable composition developable in alkaline aqueous solutions.

Photoimageable compositions for forming printed circuit boards are commonly supplied in the form of a dry film. To form the dry film, the photoimageable composition is applied as a layer to a film of relatively rigid polymeric materialm, such as polyethyleneterphthalate, which serves as a support sheet. A protective film of removable material, such as polyethylene, is applied to the other surface of the photoimageable composition layer. This laminate structure is then supplied as a roll for subsequent application to a blank for a printed circuit board.

To apply the photoimageable composition layer to a circuit board blank (generally a copper-clad fiberglass/epoxy board), the protective film is removed, the photoimageable composition layer applied to the blank and laminated thereto with heat and pressure. Subsequently the support sheet is removed.

A common problem of dry film photoresist compositions is balancing coldflow, which creates edge fusion in a roll of dry film, with the tack necessary to adhere the photoresist to the substrate during processing. Typical prior art remedies for improved adhesion are combinations of low glass transition temperature (T_{g}) binder polymers and/or high multifunctional photopolymerizable monomer content. While such combinations certainly promote adhesion, they also promote coldflow and degrade the shelf life of the dry film.

Accordingly, it is a general object of the present invention to provide a photoimageable composition suitable as a photoresist for the production of printed circuit boards which has sufficient tack for good adhesion to a blank for a printed circuit board without excess cold flow.

### Summary of the Invention

The negative-acting photoimageable composition comprises A) between about 29 and about 69 wt%, based on total weight of A) plus B) plus C), of an organic polymeric binder(s) having sufficient acid functionality to render the photoimageable composition developable in alkaline aqueous solution, the binder polymer being formed from at least about 3 wt% up to about 50 wt%, preferably at least about 5 wt%, of a hydroxyl-functional α,β-ethylenically unsaturated monomer(s); B) between about 30 and about 60 wt % (calculated relative to total weight of A) plus B) plus C)) of an addition-polymerizable component, component B) comprising a nongaseous ethylenically unsaturated compound or compounds capable of forming a polymer by free-radical initiated chain-propagating addition polymerization, component B) comprising between about 20 and about 60 wt% (calculated relative to A) plus B) plus C) ) of monomer(s) B') having multi α,β-ethylenic unsaturated functionality and at least three ethylene oxide or propylene oxide units per molecule, balance, i.e., 0 up to about 40 wt% based on total weight of A) plus B) plus C), of other α,β-ethylenically unsaturated compound(s) B"); and between about 0.5 and about 15 wt% of C) (calculated relative to total weight of A) plus B) plus C)) of an organic, radiation-sensitive free-radical generating system activatable by actinic radiation to initiate chain-propagating addition polymerization of the addition-polymerizable component B).

### Detailed Description of Certain Preferred Embodiments

Herein, unless otherwise noted, all percentages are weight percentages. Component A) (the binder polymer), photoimageable component B), and Component C) (the photoinitiator chemical system) are herein considered to equal 100 wt%, and other components, such as plasticizer, are calculated as parts relative to 100 parts of A) plus B) plus C). Molecular weights of polymers and oligomers, unless otherwise stated, are weight average molecular weights.

The invention is directed to photoimageable compositions which are developable in alkaline aqueous solution and which therefore have substantial acid functionality. Such photoimageable compositions typically have a binder polymer A) having acid functionality, typically an acid number of at least about 80, preferably at least about 100 and more preferably about 150 or more, up to about 250. The acid functionality is typically carboxylic acid functionality, but may also include, for example, sulfonic acid functionality or phosphoric acid functionality.

The binder polymer A) is typically derived from a mixture of acid functional monomers and non-acid functional monomers. Some specific examples of suitable acid functional monomers are acrylic acid, methacrylic acid, maleic acid, fumaric acid, citraconic acid, 2-acrylamido-2-methylpropanesulfonic acid, 2-hydroxyethyl acrylolyl phosphate, 2-hydroxypropyl acrylol phosphate, 2-hydroxy-alpha-acryloyl phosphate, etc. One or more of such acid functional monomers may be used to form the binder polymer.

The acid functional monomers may be copolymerized with non-acid functional monomers, such as esters of acrylic acids, for example, methyl acrylate, methyl methacrylate, hydroxy ethyl methacrylate, hydroxy ethyl acrylate, butyl methacrylate, octyl acrylate, 2-ethoxy ethyl methacrylate, t-butyl acrylate, n-butyl acrylate, 2-ethyl hexyl acrylate, n-hexyl acrylate, 1,5-pentanediol diacrylate, N,N-diethylaminoethyl acrylate, ethylene glycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, 2,2-di(p-hydroxyphenyl)-propane dimethacrylate, triethylene glycol diacrylate, polyoxyethyl-2-2-di(p-hydroxyphenyl)-propane dimethacrylate, triethylene glycol dimethacrylate, polyoxypropyltrimethylol propane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, and 1,4-benzenediol dimethacrylate; styrene and substituted styrene, such as 2-methyl styrene and vinyl toluene and vinyl esters, such as vinyl acrylate and vinyl methacrylate to provide the desired acid number.

Binder polymer A) of the photoimageable compositions of the present invention has a weight average molecular weight between about 20,000 and about 200,000, preferably at least about 80,000.

Herein, at least about 3 wt% of the monomers which form the binder polymer A) have hydroxyl functionality, preferably from about 5 to about 15 wt%, up to about 50 wt%. The wt% of hydroxyl functional monomers is measured relative to the total weight of binder polymer if two or more binder polymers are utilized. The -OH functionality renders the binder polymer hydrophilic. Typical hydroxyl-functional monomers for forming -OH functional polymers are hydroxyethyl methacrylate (HEMA) and hydroxyethyl acrylate (HEA), HEMA being preferred for providing chemical resistance. The binder polymer A) may actually be a mixture of binder polymers, providing that the binder polymers are formed, in total, from the amounts of hydroxyl-functional monomer set forth above. Thus, for example, a photoimageable composition having 1:1 (by weight) mixture of a first binder polymer formed from 10 wt% hydroxyl functional monomer and a second binder polymer formed from 0 wt% hydroxyl functional monomer would be considered, for purposes of this invention, as being formed from 5 wt% hydroxyl functional monomer.

Hydrophilic monomers, including those formed at least in part from -OH functional monomers, have been proposed previously for use in forming binder polymers. Hydrophilic binder polymers having -OH functionality process better in developing systems and rinse off better. However, as most monomers used in photoimageable compositions of this type tend to be hydrophobic, incompatibility between hydrophilic binder polymer and hydrophobic monomer composition tends to force monomers (and auxiliary materials with the monomers) out of the resist in the form of leaching to plating systems, monomer bleeding into polyethylene wraps, or fusing out of the ends of rolls.

Accordingly, to form a more compatible system, at least about 20 wt% relative to total amount of A) plus B) plus C), up to the total amount of photopolymerizable component B) is monomer B') having multi α,β-ethylenic unsaturated function and at least 3 ethylene glycol (-O-CH₂-CH₂-) units and/or propylene glycol (-O-CH₂-CH(CH₃)-) or (-O-CH(CH3)-CH₂-) units. In such monomers, the α,β-ethylenically unsaturated moieties, typically acrylic or methacrylic units, are esterified to the glycol units. The ethylene and/or propylene glycol units render the monomers hydrophilic and therefor more compatible with the hydrophilic polymer. Ethylene glycol units are preferred to propylene glycol units, being more hydrophilic. If propylene glycol units are used, typically a greater number of such units, e.g., about 5 or more, are used per monomer molecule. Examples of monomers having multi α,β-ethylenic unsaturated function in addition to three or more glycol units include, but are not limited to, ethoxylated (3 moles) trimethylolpropane triacrylate, tetraethyleneglycol diacrylate,

The balance of photopolymerizable component B), used at 0 to about 30 wt% of the photoimageable composition (calculated relative to total weight of A) plus B) plus C) is B"), typically a monomer, dimer or short chain oligomer having ethylenic unsaturation, particularly α,β-ethylenic unsaturation, including monofunctional compounds and compounds having α,β-ethylenic unsaturation functionality 2 or greater. Suitable optional photopolymerizable compounds B") include, but are not limited to, the monomers recited above as suitable for forming binder polymers , particularly the non-acid functional compounds.

Ethoxylated or propoxylated monomers have the further advantage of being relatively less toxic and less irritating than most photopolymerizable monomers, e.g., they give better Draize Test results in which drops are introduced into the eyes of rabbits.

The combination of hydrophilic polymers and hydrophilic monomers results in reduction in leaching, reduction in monomer bleed, and reduction in fusion. At the same time, the compositions have excellent tack for adhesion to printed circuit board blanks.

Furthermore, it is found that the formation of binder polymers from HEMA and/or HEA results in a lowering of T_{g}. Consequently, adhesion-producing tack is achieved using less monomer, further minimizing leaching and cold-flow.

To initiate polymerization of the monomers upon exposure to actinic radiation, the photoimageable composition contains a photoinitiator chemical system. Suitable photoinitiators include, for example, 9-phenyl acridine, benzoin ethers, benzil ketals, acetophenones, benzophenones and related compounds with amines. Also, suitable 9-phenyl acridine homologues, such as those described in U.S. Patent No. 5,217,845, the teachings of which are incorporated herein by reference, are useful photoinitiators.

Processing of the photoimageable composition is in a conventional manner. In a typical procedure, a photoimageable composition layer, either formed from a liquid composition or transferred as a layer from a dry film, is applied to a copper surface of a copper-clad board. The photoimageable composition layer is exposed to actinic radiation through appropriate artwork. Exposure to actinic radiation polymerizes the monomer in the light-exposed areas, resulting in a cross-linked structure that is resistant to developer. Next, the composition is developed in dilute alkaline aqueous solution, such as a 1% sodium carbonate solution. The alkali solution causes salt formation with the carboxylic groups of the binder polymers, rendering them soluble and removable. After development, an etchant may be used to remove copper from those areas where the resist was removed, thereby forming a printed circuit. The remaining resist is then removed using an appropriate stripper.

The invention will now be described in greater detail by way of specific examples.

### Examples

(Examples D, F, G, and H in accordance with the invention: A, B, C and E comparative)

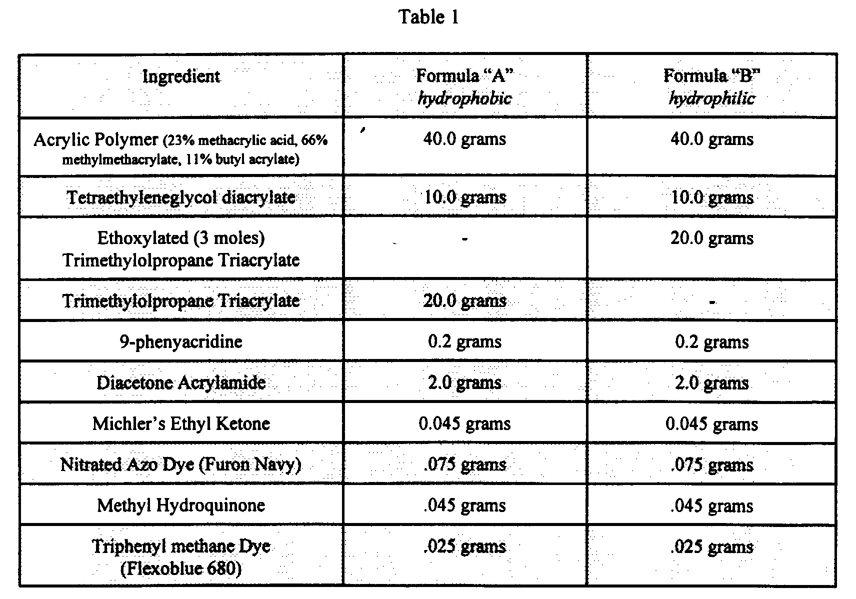

All compositions (Tables 1, 3, and 5) were prepared in 7:1 2-Butanone:2-Propanol at approximately 50% solids. The solutions were coated onto biaxially oriented 72 gauge polyester film and dried to approximately 1% or less retained solvent. The coated mixtures were then laminated onto mechanically scrubbed 1 oz./FR-4/1 oz. clad copper composite using a hot roll laminator at 110°C at 2 meters/minute and 3 bar pressure.

The laminated material was then imaged on a UV printer through an appropriate phototool with an adjusted exposure to obtain a copper step of 7 as measured with a Stouffer® 21 step wedge (approximately 20 mJ/cm²). The exposed panels were then developed in a 1% sodium carbonate monohydrate solution at 29°C using a conveyorized spray developer at about 26 psi with residence time adjusted so that the break point occurred at 40% to 50% of the chamber length (unless otherwise noted in the specific example), followed by several spray rinses using tap water and the deionized water.

Etching was accomplished using a 2N cupric chloride/hydrochloric acid solution at 48°C in a conveyorized etcher equipped with multiple spray nozzles. The etched boards were then stripped of the imaged, developed and etched photo resist in a 3% sodium hydroxide solution at 54°C in a conveyorized stripping unit equipped with multiple spray nozzles followed by a spray rinse of tap water.

Process responses for the examples are cited at various points throughout the above procedure are given in Table 2 below:

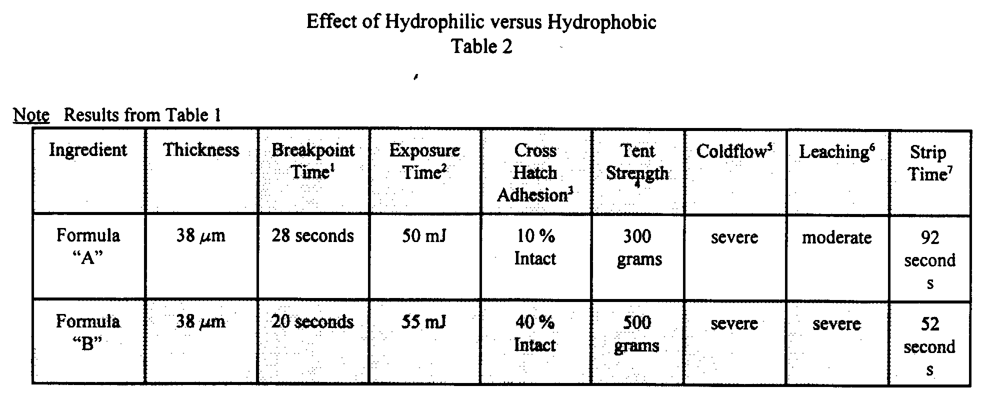

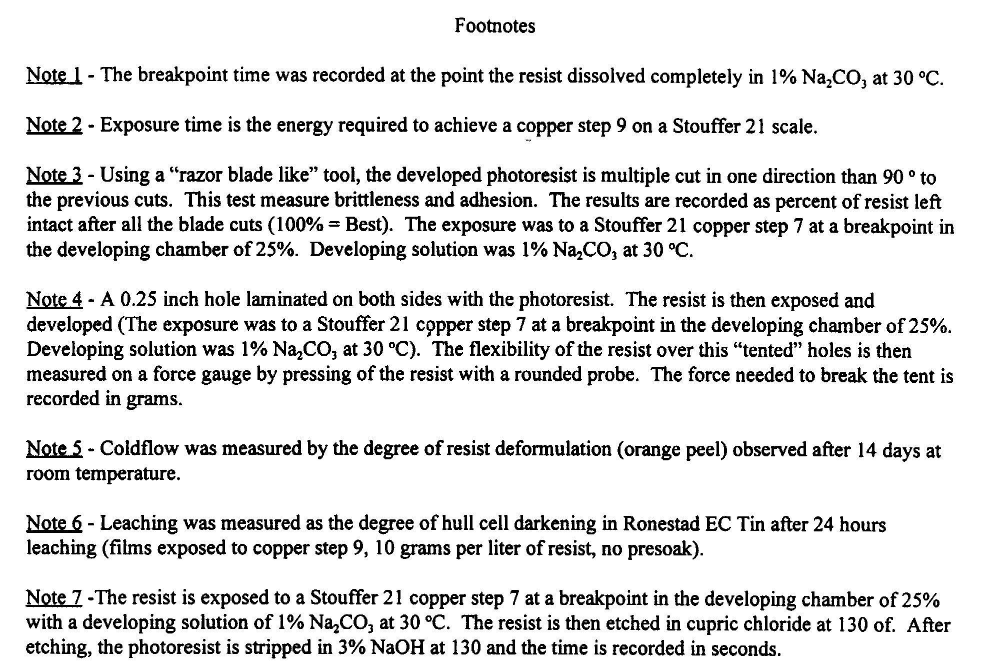

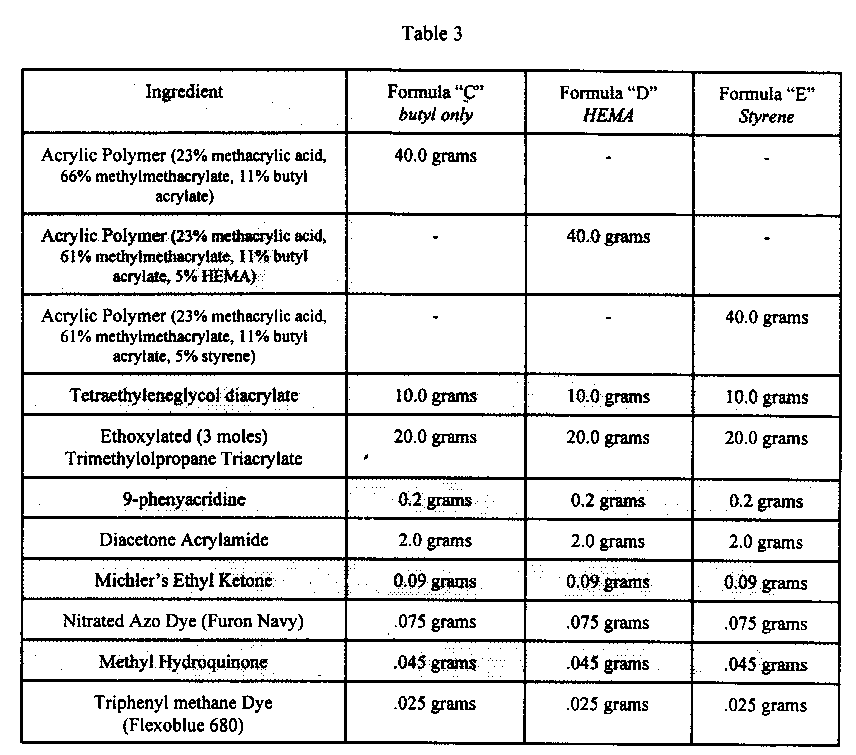

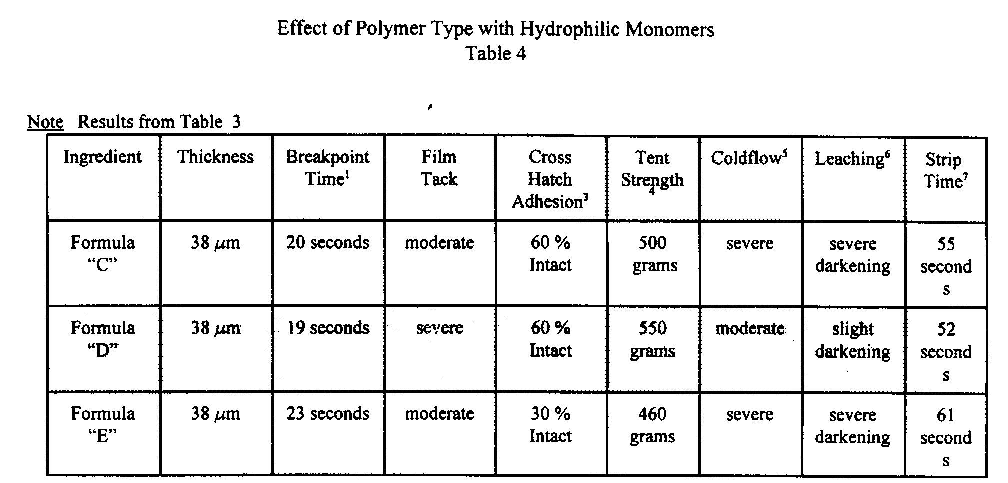

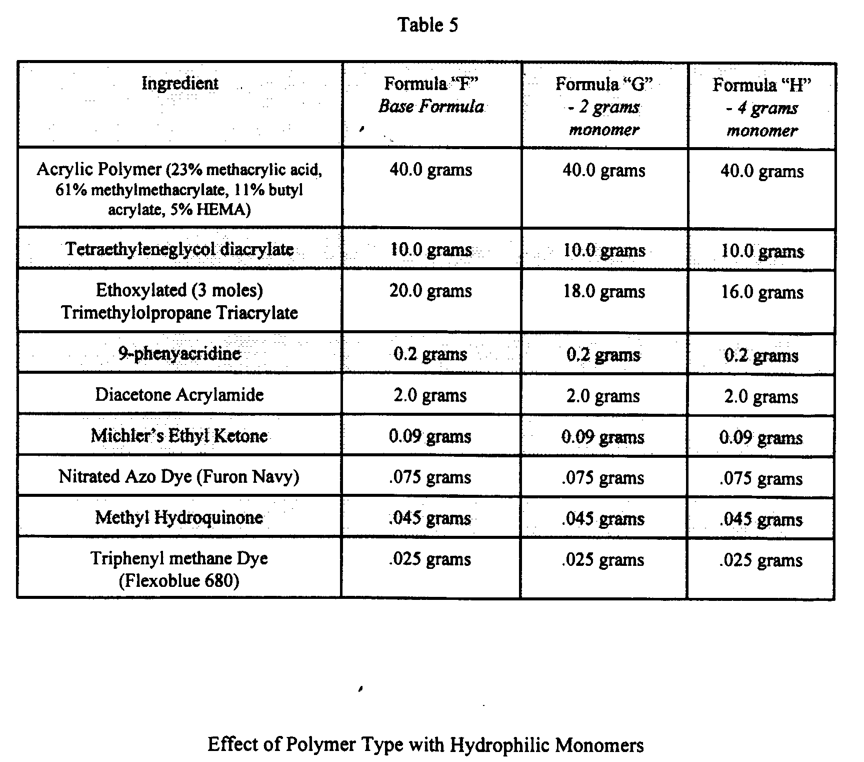

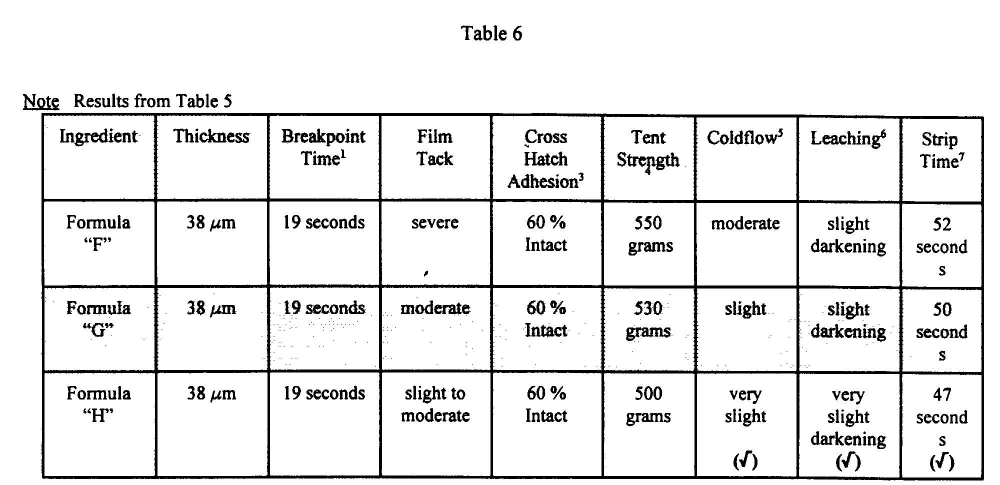

Examples A and B demonstrate that the use of hydrophilic monomer alone does not produce the desired results. Example D demonstrates that when using hydrophilic monomer in accordance with a hydrophilic polymer produces superior results relative to comparative Examples C and E which use hydrophobic polymers. Examples F-H demonstrate that when using the combination of hydrophilic monomer and hydrophilic (HEMA containing) binder polymer, it is possible to use less monomer, yet, to the extent shown in these examples, obtain increasingly superior results.

## Claims

1. A photoimageable composition comprising components (A), (B) and (C), namely:
A) between 29 and 69 wt%, based on total weight of (A) plus (B) plus (C), of an organic binder polymer(s) having sufficient acid functionality to render said photoimageable composition developable in alkaline aqueous solution, said binder polymer(s) being formed from between 3 to 50 wt% of a hydroxyl-functional α,β-ethylenically unsaturated monomer,
B) between 30 and 60 wt%, based on total weight of (A) plus (B) plus (C), of an addition polymerizable component comprising α, β-ethylenically unsaturated compounds, said component (B) comprising
B') a monomer(s) having multi α, β-ethylenically unsaturated functionalicy and at least 3 ethylene glycol and/or propylene glycol units per molecule,
said monomer(s) (B') being present in an amount of at least 20 wt%, based on total weight of (A) plus (B) plus (C) up to the balance of component (B), and
B") 0 to 40 wt% based on total weight of (A) plus (B) plus (C) of other α, β-ethylenically unsaturated compound(s), and
C) between 0.5 and 15 wt%, based on total weight of (A) plus (B) plus (C) of an organic, radiation-sensitive free-radical generating system.

2. A photoimageable composition according to Claim 1 wherein said free-radical generating system (C) comprises 9-phenyl acridine.

3. A photoimageable composition according to claim 1 or claim 2 wherein the binder polymer (A) has an acid functionality of at least 80.

4. A photoimageable composition according to any preceding claim wherein the binder polymer (A) is derived from a mixture of acid functional monomers and non-acid functional monomers.

5. A photoimageable composition according to any preceding claim wherein the binder polymer (A) has a weight average molecular weight of 20,000 to 200,000.

6. A photoimageable composition according to any preceding claim wherein 5 to 15 weight % of the monomers forming the binder polymer (A) have hydroxyl functionality.
